# EUROPEAN PATENT APPLICATION

(11) **EP 4 718 680 A2**
(43) Date of publication of application: **01.04.2026**
(21) Application number: 25200837.0
(22) Date of filing: 08.09.2025
(51) Int. Cl.: H02J 7/63

(54) **BATTERY UNDER VOLTAGE LOCK OUT AND REVERSE POLARITY CHARGER PROTECTION CIRCUITRY**

(30) Priority: 09.09.2024 US 202463692209 P
(71) Applicant: Hill-Rom Services, Inc., Batesville, IN 47006-9167 (US)
(72) Inventor: GOVEA, Javier Alan, Batesville, 47006 (US)
(74) Representative: Reddie & Grose LLP

(57) **Abstract**

A battery protection circuit (100) that prevents an over-discharge condition of a battery (16) and a reverse polarity battery charger protection circuit (200). The battery protection circuit (200) includes a battery input (70) configured to receive a battery voltage, a reference voltage input (19) configured to receive a low battery reference voltage, a comparator (U15) for comparing a first signal indicative of the battery voltage with a second signal indicative of the reference voltage and generating an output indicative of a low battery voltage, a feedback resistor (R172) coupling the output of the comparator (U15) to the reference voltage input to create hysteresis and a battery disconnect circuit (100) to disconnect the battery voltage applied to a load (34). The reverse polarity battery charger protection circuit (200) has relay and a diode to detect reverse polarity connection of the charge to the battery (16).

## Description

The present disclosure generally relates to circuitry protection of battery and charging systems, and more particularly relates to preventing over-discharge of a battery and reverse polarity protection of a battery charger.

Batteries such as lead-acid batteries are frequently used to power electrical loads. The battery may be made up of one or more battery cells which are designed to operate within a specific voltage level range. It may be desirable to provide for efficient energy consuming circuitry that prevents battery over-discharge and reverse polarity protection of a battery charger.

According to one aspect of the present disclosure, a battery protection circuit includes a battery input configured to receive a battery voltage, a reference voltage input configured to receive a low battery reference voltage, a comparator for comparing a first signal indicative of the battery voltage with a second signal indicative of the reference voltage and generating an output indicative of a low battery voltage, a feedback resistor coupling the output of the comparator to the reference voltage input to create hysteresis and a battery disconnect circuit to disconnect the battery voltage applied to a load.

According to another aspect of the present disclosure, a battery system has a battery having one or more battery cells and generating a battery voltage, an electrical load configured to receive the battery voltage to power the electrical load, and a battery protection circuit. The battery protection circuit includes a battery input configured to receive a battery voltage, a reference voltage input configured to receive a low battery reference voltage, a comparator for comparing a first signal indicative of the battery voltage with a second signal indicative of the reference voltage and generating an output indicative of a low battery voltage, a feedback resistor coupling the output of the comparator to the reference voltage input to create hysteresis, and a battery disconnect circuit to disconnect the battery voltage applied to a load.

According to yet another aspect of the present disclosure, a reverse polarity battery charger protection circuit has a battery charger input configured to receive a power supply voltage, a battery connector configured to couple with first and second polarity outputs of a battery, a battery charger input configured to receive a charging voltage from a battery charger, a relay coupled in series with the battery charger input, a diode coupled in parallel with the battery charger and a transistor coupled to the relay and the diode. The diode and relay allow charging of the battery with the battery charger and prevent charging of the battery with the battery charger when a reverse polarity connection of a battery to the battery connector is detected.

According to yet another aspect of the present disclosure, a battery charging system has a battery having one or more battery cells and generating a battery voltage, a battery charger generating a charging voltage to charge the battery and a reverse polarity battery charging protection circuit coupling the battery charger to the battery. The reverse polarity battery charging protection circuit has a battery charger input configured to receive a power supply voltage, a battery connector configured to couple with first and second polarity outputs of a battery, a battery charger input configured to receive a charging voltage from a battery charger, a relay coupled in series with the battery charger input, a diode coupled in parallel with the battery charger and a transistor coupled to the relay and the diode, wherein the diode and relay allow charging of the battery with the battery charger and prevent charging of the battery with the battery charger when a reverse polarity connection of a battery to the battery connector is detected.

The invention will now be further described by way of example with reference to the accompanying drawings, in which:
FIG. 1 is a side perspective view of a patient support apparatus equipped with a battery and charging system in a medical facility, according to one example;
FIG. 2 is a block diagram of the battery and charging system having undervoltage battery protection circuitry and reverse polarity battery charger protection circuitry, according to the present disclosure;
FIG. 3 is a circuit diagram illustrating the undervoltage battery protection circuitry, according to one aspect of the present disclosure; and
FIG. 4 is a circuit diagram illustrating the reverse polarity battery charger protection circuitry, according to another aspect of the present disclosure.

The present illustrated embodiments reside primarily in combinations of method steps, systems, devices, and apparatus components related to systems, methods, and programs for visually generating a recreation of a medical incident associated with a patient within a medical environment. Accordingly, the apparatus components and method steps have been represented, where appropriate, by conventional symbols in the drawings, showing only those specific details that are pertinent to understanding the embodiments of the present disclosure so as not to obscure the disclosure with details that will be readily apparent to those of ordinary skill in the art having the benefit of the description herein. Further, like numerals in the description and drawings represent like elements.

The specific structures and processes illustrated in the attached drawings, and described in the following specification are simply exemplary embodiments of the inventive concepts defined in the appended claims. Hence, specific dimensions and other physical characteristics relating to the embodiments disclosed herein are not to be considered as limiting, unless the claims expressly state otherwise.

The terms "including," "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element preceded by "comprises a . . . " does not, without more constraints, preclude the existence of additional identical elements in the process, method, article, or apparatus that comprises the element.

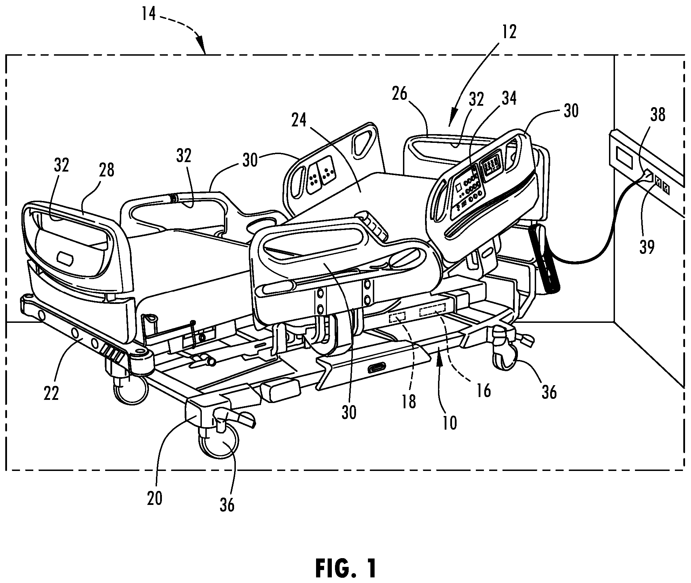

Referring to FIGS. 1-4, reference 10 generally designates a battery and charging system shown in one example embodied on a patient support apparatus 12 for use in a medical facility 14. The battery and charging system 10 has a battery 16 configured to store electrical energy and supply electrical power which may be used as a backup to a main power supply. The battery and charging system 10 includes an undervoltage battery protection circuit to cut off electrical power supplied by the battery 16 to electrical loads during an over-discharge condition that result in a low or undervoltage. The battery and charging system 10 also includes a battery charger 18 that is configured to charge the battery 16. The battery and charging system 10 further includes a reverse polarity battery charger protection circuit to protect the battery charger 18 in the case of a reverse polarity connection of the battery terminals to the charging circuitry in a manner that reduces leakage current through the battery and charger circuit network.

Referring to FIG. 1, the patient support apparatus 12 is illustrated in one example as a transport stretcher located within the medical facility 14. It is contemplated that the patient support apparatus 12 may be configured as other types of stretchers, medical beds, other types of beds, mattresses, examination tables, operating tables, recliners, or any other suitable structures for supporting a patient and electrically powered devices also referred to as electrical loads and having a battery and charging system, without departing from the teachings herein. Moreover, the medical facility 14 shown in this example may be any suitable location for providing treatment to the patient on the patient support apparatus 12.

The patient support apparatus 12 is shown in one example having an upper frame 22 supported on a base frame 20. The upper frame 22 may be generally adjustable relative to the base frame 20 such as to position the height, tilt, etc. The upper frame 22 includes a support surface for supporting a mattress 24. Different portions of the mattress 24 may be adjustable relative to the upper frame 22. For example, a portion of the mattress 24 at the head end 26 or the foot end 28 may extend upward at an angle relative to the support surface of the upper frame 22.

The patient support apparatus 12 is shown having various features for transporting and treating patients. For example, the patient support apparatus 12 includes handles 32 located in the siderail assemblies 30 as well as in the head end 26 and the foot end 28 which enable the transportation of the patient support apparatus 12 to different locations within the medical facility 14 and elsewhere.

The patient support apparatus 12 may include various electrically powered devices that may be equipped on the patient support apparatus 12 and electrically powered to thereby define electrical loads 34. For example, the patient support apparatus 12 may include various powered devices such as electric motors that may be used to actuate and reconfigure the mattress 24 such as to incline or decline portions of the mattress 24 and raise or lower the mattress 24. According to other examples, electronic devices such as user input and output devices in the form of touchscreen displays and switches may be powered by a plug-in main power supply or by the battery 16. In addition, electronic devices in the form of user interfaces such as tablets, laptops, smartphones, etc. may be powered on the patient support apparatus 12 and may be connected to the power sources via electrical connections such as via power plugs, USB/A, USB/B and USB/C connectors, for example. It should be appreciated that any of a number of electrical loads 34 may be connected to the patient support apparatus 12 and powered by the main power supply or the battery 16.

The base frame 16 is further shown supported on wheels 36 that engage the underlying floor surface of the medical facility 14. The wheels 36 are generally coupled to the base frame 20 via an axle. The wheels 36 may be in the form of casters configured to rotate in a power drive mode via one or more electric motors as additional electrical loads powered by the main power supply or the battery 16 in order to propel the patient support apparatus 12 for transportation by a caregiver, a medical professional or other users.

Still referring to FIG. 1, the patient support apparatus 12 is shown having an electrical power cord with a power plug 38 configured to be connected to a main alternating current (AC) power supply 39 such as in a wall or floor of the medical facility 14. Accordingly, the main AC electrical power supplied by a power distribution network in the medical facility 14 may be distributed and used to power the various electrical loads 34 on the patient support apparatus 12. The AC main power may be converted to direct current (DC) power via an AC to DC converter to supply a DC voltage, such as about 28 volts, for example. The battery 16 is a rechargeable battery that may be used to power the electrical loads when the AC electrical plug 38 is disconnected from the AC main power supply 39, such as when the patient support apparatus 12 is transported or if the AC main power supply 39 is otherwise not available. The battery charger 18 is configured to charge the rechargeable battery 16 by supplying electrical power from the AC power supply 39 received via the electrical plug 38 which is converted from AC electrical power to DC electrical power and used to charge the rechargeable battery 16.

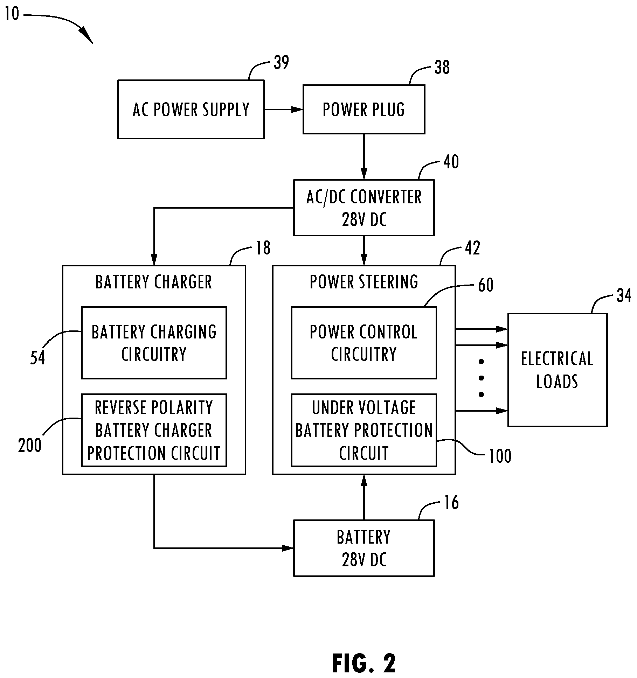

Referring to FIG. 2, the battery and charging system 10 is shown coupled to the main AC power supply 39 which may include an electrical power distribution network provided within the medical facility 14 which may supply the main AC electrical power. According to one example, the main AC electrical power may be supplied at a voltage of 120 volts AC or may otherwise include a voltage of 240 volts AC or other acceptable voltage levels. The main AC power is supplied to the patient support apparatus 12 via the power electrical cord and plug 38. The main AC power may be converted to a DC voltage such as about 28-volt DC power. It should be appreciated that it is conceivable that the medical facility 14 may supply the 28-volt DC main power supply that may have been converted via AC to DC converter circuitry provided within the medical facility 14.

The converted DC electrical main power supplied by the AC to DC converter 40 serves as the main power supply Vₚₛ for powering the electrical loads and charging the rechargeable battery 16. The main power Vₚₛ is provided as an input to power steering control 42. In addition, the main power Vₚₛ is supplied to the battery charger 18. The power steering control 42 also receives the battery power V_{bat} supplied by the battery 16. The power steering control 42 includes power control circuitry 60 which controls which power source, namely the main power Vₚₛ or battery power V_{bat}, is used to supply electrical power to one or more electrical loads 34. When the AC power plug 38 supplies the main power Vₚₛ, the one or more electrical loads 34 are powered by the electrical power received from the AC to DC converter 40 which was converted from the AC power supply. If the battery and charging system 10 is not connected to the AC main power supply 39 or the AC main power Vₚₛ is not available, such as when the patient support apparatus 12 is transported or located out of reach of the AC power supply 39, then the battery 16 is utilized to supply the DC battery power V_{bat} to the one or more electrical loads 34. In doing so, the power steering control 42 determines which power source is to be supplied to the one or more electrical loads 34.

The DC voltage which is supplied from the AC main power supply and converted by the AC to DC converter 40 is also supplied to the battery charger 18 which in turn is used to charge the rechargeable battery 16. According to one example, 120-volt AC main power that is converted to about 28 volts DC by the AC to DC converter 40 is used to charge the rechargeable battery 16 to a fully charged voltage of approximately 28 volts DC. The battery charger 18 may include known battery charging circuitry 54.

The battery 16 is a rechargeable battery that may be configured as a lead acid battery, according to one example. The lead acid battery 16 may include a plurality of electrochemical cells coupled in series with a number of cells sufficient to generate the desired battery output voltage. For example, the lead acid battery may include fourteen cells, each of which outputs approximately 2.1 volts when fully charged, for a total battery output voltage of approximately 28 volts. According to another example, 12 cells may be coupled in series to produce a 24-volt output system. It should be appreciated that the undervoltage battery protection circuit 100 advantageously cuts off electrical power supplied to the electrical loads 34 when a sufficiently low voltage is detected to prevent the output voltage of each battery cell from dropping below 1.75 volts to prevent damage to the battery cells and hence the battery.

The power steering control 42 is further shown having an undervoltage battery protection circuit 100. The undervoltage battery protection circuit 100 detects a low voltage level of the battery output voltage V_{bat} and cuts off electrical power supplied from the battery 16 to the electrical loads 34 to prevent the one or more electrical loads 32 from drawing power from the battery 16 when the battery voltage is low to prevent over-draining the battery 16. The undervoltage battery protection circuit 100 advantageously employs hysteresis to prevent the electrical loads 34 from being re-applied repeatedly to the battery 16 during an undervoltage condition, particularly when the voltage of the battery cells, and hence the battery 16, increase somewhat and stabilizes with an open circuit voltage. For example, when a battery 16 that normally supplies about 28 volts DC drops to a voltage of approximately 21 volts DC, the undervoltage battery protection circuit 100 advantageously disconnects the battery voltage V_{bat} from the electrical loads 34 and prevents reconnecting the electrical loads 34 to the battery 16 until the battery 16 reaches a sufficiently higher voltage, such as about 24 volts DC. This prevents the electrical loads 34 from cyclically draining the battery 16 sufficiently during an undervoltage condition which can lead to damage or reduced performance of the battery 16. It should be appreciated that the undervoltage battery protection circuit 100 may be integrally embodied on a circuit board with the power control circuitry 60 associated with the power steering control or may be separate therefrom.

The battery charger 18 is shown having reverse polarity battery charger protection circuitry 200. The reverse polarity battery charger protection circuitry 200 detects a reverse polarity electrical connection of the positive (+) and negative (-) battery 16 terminals to the battery charger 18 to protect the battery charger 18 in case of a reverse polarity connection in a manner that eliminates back-feeding into the charging circuitry and reduces battery current leakage through the charger network. It should be appreciated that the reverse polarity battery charger protection circuit 200 may be integrally embodied on a circuit board with the battery charging circuitry 54 associated with the battery charger 18 or separate therefrom.

### Battery Protection Circuit

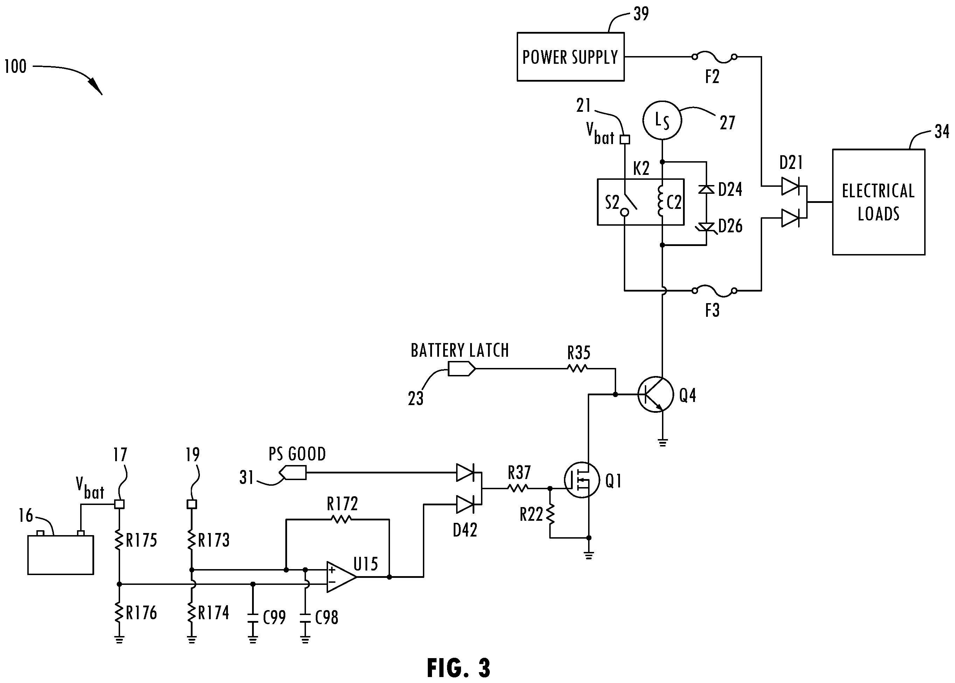

Referring to FIG. 3, the undervoltage battery protection circuit 100 is illustrated operatively coupled between the battery 16 and the electrical loads 34. The undervoltage battery protection circuit 100 may be implemented as part of the power steering control 42 which includes power control circuitry 60. The power control circuitry 60 includes circuitry for controlling the selection of one of the main power supply Vₚₛ and the battery power supply V_{bat} that is to be used to supply electrical power to the electrical loads 34. The undervoltage battery protection circuit 100 detects a low battery output voltage V_{bat} indicative of an undervoltage condition of the battery 16 and disconnects the battery voltage V_{bat} from the electrical loads 34 to cut off the supply of battery power to the electrical loads 34 when the battery voltage V_{bat} drops below an acceptable first voltage level and reconnects the battery voltage V_{bat} to the electrical loads 34 when the battery voltage V_{bat} increases to a greater second acceptable voltage level.

The undervoltage battery protection circuit 100 includes a battery input 17 receiving the battery voltage V_{bat} from the battery 16, which in one example has a DC voltage of about 28 volts. The undervoltage battery protection circuit 100 also has a reference voltage input 19 that is configured to receive a low battery reference voltage V_{ref}. The undervoltage battery protection circuit 100 further includes a comparator U15 for comparing a first signal indicative of the battery voltage V_{bat} applied to a first input (-) with a second signal indicative of the reference voltage V_{ref} applied to a second input (+) and generating an output indicative of a high or low battery voltage. The first signal is a first voltage that is generated by applying the battery voltage V_{bat} across a first resistor divider network that includes resistors R175 and R176. The first resistor divider network divides the battery voltage V_{bat} to a proportioned voltage such as in a range of 0-5 volts. The second signal is a second voltage that is generated as a proportion of the reference voltage V_{ref} applied to a second resistive divider network that includes resistors R173 and R174. The second signal voltage is likewise proportioned within a voltage range of 0-5 volts, for example.

The first resistor divider network made up of resistors R175 and R176 advantageously employs high resistance resistors. For example, resistor R175 may have a resistance of approximately 750 kΩ and resistor R176 may have a resistance of approximately 113 kΩ, according to one example. In this example, the second resistor divider network made up of resistors R173 and R174 may likewise have a high resistance. For example, resistor R173 may have a resistance of about 100 kΩ, and resistor R174 may have a resistance of about 150 kΩ. The resistors R175, R176, R173 and R174 forming the first and second resistor divider networks preferably each have a sufficiently high resistance value such as greater than 50 kΩ. As a result of the relatively high resistance resistors R175, R176, R173 and R174, the first and second resistor divider networks advantageously draw a very small amount of electrical current thereby resulting in less energy consumption which is particularly advantageous when drawing electrical power from the battery 16.

The first voltage indicative of the battery voltage V_{bat} is compared with the second voltage indicative of the reference voltage V_{ref} by the comparator U15. When the first voltage is greater than the second voltage, the comparator U15 generates a low output voltage of a zerovolt signal. According to one example, the first voltage may be approximately five volts for a 28-volt V_{bat}, and the second voltage may be a lesser voltage which represents an undervoltage cutout voltage of the battery dropping to a cutoff voltage of approximately 21 volts. As such, the comparator U15 detects when the battery voltage V_{bat} of 28 volts drops below the cutoff voltage of 21 volts and, when this occurs, generates a high output voltage of five volts.

The undervoltage battery protection circuit 100 includes a feedback resistor R172 connected in parallel with the comparator U15 that couples the output of the comparator U15 to the proportioned reference voltage input to create hysteresis. The feedback resistor R172 may have a resistance value of 168 kΩ, for example. The hysteresis provides a deadband voltage range such as three volts of deadband that prevents the output of the comparator U15 from switching between high and low output signals until the voltage difference at the inputs of the comparator U15 is sufficiently close. For example, when an undervoltage condition is detected, the hysteresis requires that the battery voltage V_{bat} rise to a higher voltage level of 24 volts, for example, before the comparator U15 may generate a low voltage output of zero volts which may allow power to be resupplied to the electrical loads 34. The undervoltage battery protection circuit 100 includes a battery disconnect circuit shown having a battery connect relay K2 operable to disconnect the battery voltage applied to one or more electrical loads 34. When the output of the comparator U15 outputs a low voltage signal of zero volts, the battery voltage V_{bat} is applied to the one or more electrical loads. When the output of the comparator U15 generates a high signal of five volts, the battery disconnect relay K2 disconnects the battery voltage V_{bat} from the one or more electrical loads 34.

The first and second inputs of the comparator U15 are each coupled to capacitors. For example, the first input (-) is coupled to a capacitor C99, and the second input (+) is coupled to a capacitor C98. Capacitors C99 and C98 are each coupled to ground and advantageously reduce noise in the input signals that are input into the comparator U15 to provide for a more stable signal comparison.

The battery disconnect circuit is shown including the battery connect relay K2 which includes a relay switch S2 and a relay coil C2 which, when energized, actuates the relay switch S2 from the normally open circuit position to the closed circuit position. The battery connect relay K2 coil 2C is coupled in parallel to a pair of reverse connected diodes D24 and D26 which remove signal chatter from the battery connect relay K2.

The battery connect relay K2 is coupled to a transistor Q4 and a transistor Q1 which may be configured as an N-type MOSFET. The N-type MOSFET transistor Q4 is coupled to a battery latch input 23 via a resistor R35 to receive a battery latch signal which turns on transistor 24 when the battery 16 is available to supply power and transistor Q1 is turned off. Transistor Q1 is coupled to the output of a logic OR gate made up of a pair of diodes 42. The logic OR gate configured with diodes D42 has a first input coupled to the output of the comparator U15, and a second input coupled to a PS Good input 31 to receive a main power supply good signal indicative of the main power supply availability. The OR gate D42 turns on transistor Q1 across resistors R37 and R22 when comparator U15 detects an undervoltage condition with the battery voltage V_{bat} is less than the cutout voltage or when the main power supply voltage Vₚₛ is available which generates an output to turn on transistor Q1 which short circuits the battery latch input 23 signal to ground to turn off transistor Q4. This prevents the battery 16 from supplying the electrical power to the electrical loads 34.

When the battery 16 is available and the comparator U15 detects the battery voltage V_{bat} is above the undervoltage cutoff voltage plus the hysteresis transistor Q1 is turned on which turns on transistor Q4 so that electric current passes through relay coil C2 from a load switch signal Lₛ at input 27 to ground to energize the relay coil C2. When the relay coil C2 is energized, the relay switch S2 forms a closed circuit. When the relay switch S2 of relay K2 is closed, power from the battery voltage V_{bat} is supplied through fuse F3 and one of diodes D21 to supply the battery voltage V_{bat} to the electrical loads 34.

In addition, the main power supply 39 with voltage Vₚₛ is supplied via a fuse F2 to the other of diodes D21 such that the main power supply may supply power to the electrical loads 34 if available. The main power supply Vₚₛ serves as the power supply when available to power the electrical loads 39. When the main power supply is not available, the PS Good input 31 receives a low voltage signal. When the battery voltage V_{bat} drops below the cutoff voltage threshold in an undervoltage condition, transistors Q1 and Q4 turn off to prevent current flow through relay coil C2 of relay K2 such that relay switch S2 remains in the open circuit position to disconnect the battery voltage V_{bat} from the electrical loads 34 and thereby prevent further draining of electrical energy from the battery 16. When the battery 16 is sufficiently charged above a higher second threshold as established by the hysteresis, transistors Q1 and Q4 turn back on to reapply current through relay coil C2 of relay K2 to thereby close relay switch S2 to allow the battery voltage V_{bat} to be reconnected to the electrical loads 34.

Accordingly, it should be appreciated that the undervoltage battery protection circuit 100 advantageously provides for hysteresis to prevent cyclical disconnecting and reconnecting of the battery voltage V_{bat} and further draining of the battery 16 in a manner that draws very little or a minimal amount of current. It should be appreciated that the undervoltage battery protection circuit 100 may be employed for use on a patient support apparatus 12 as shown and described herein. It should further be appreciated that the undervoltage battery protection circuit 100 may be employed for use with a rechargeable battery on other devices for powering other electrically powered loads.

### Battery Charger Protection Circuit

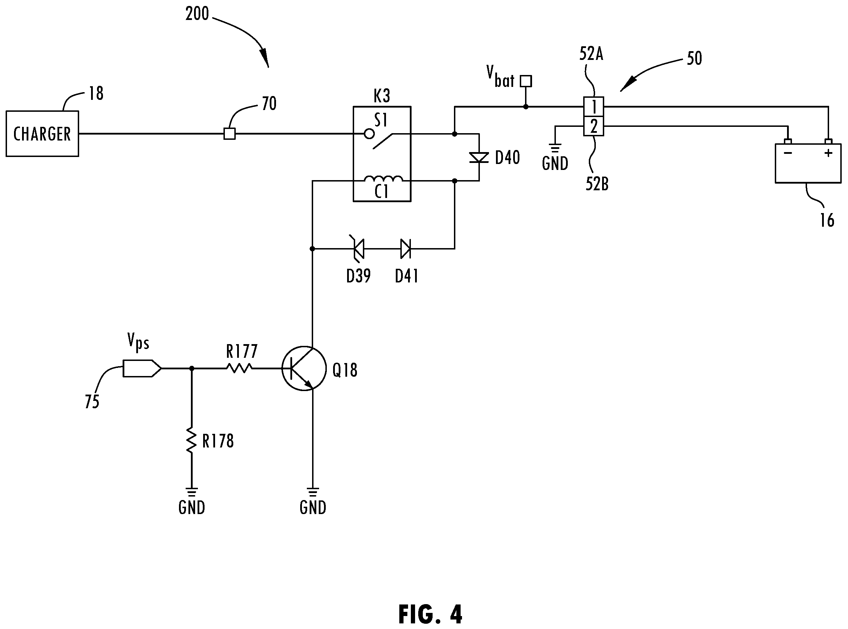

Referring to FIG. 4, the reverse polarity battery charger protection circuit 200 is illustrated operatively coupled between the battery charger 18 and the battery 16. The reverse polarity battery charger protection circuit 200 may be implemented as part of the battery charger 18 and the battery charging circuitry 54 or may be included in a separate module. The battery charger protection circuitry 200 receives DC electrical power from the battery charger 18 and supplies the DC electrical power to the rechargeable battery 16 which is connected to a battery connector 50. The battery connector 50 has a pair of terminals including a first terminal 52A and a second terminal 52B which are configured to connect to the two different polarity terminals on the battery 16. For example, the first terminal 52A may be configured to electrically connect to a positive (+) battery terminal to receive a positive polarity voltage, and the second terminal 52B may be configured to electrically connect to a negative (-) battery terminal to receive a negative polarity which is shown coupled to ground. As such, the battery charger 18 may supply a specified voltage across the terminals 52A and 52B of the battery connector 50 such as 28 volts to charge the battery 16 up to a maximum fully charged voltage of about 28 volts.

The battery charger protection circuit 200 includes a battery charger input 70 configured to receive the charger power supply voltage from the battery charger 18 and has the battery connector 50 as an output configured to couple with the first and second polarity output terminals 52A and 52B which in turn connect to the battery 16. The battery charger protection circuit 200 includes a relay K3 coupled in series with the battery charger input 70 and hence the battery charger 18. The battery charger protection circuit 200 further includes a diode D40 coupled in parallel with the battery charger 18. The relay K3 includes a relay coil C1 and a relay switch S1. The relay switch S1 is connected in series with the charger 18 and the first terminal 52A of the battery connector 50. The relay K3 coil C1 is coupled in parallel to a pair of reverse connected diodes D39 and D41 to remove signal chatter from the relay K3.

The relay coil C1 is coupled in series to a transistor Q18 and the diode D40. The diode D40 and the relay K3 allow charging of the battery 16 with the battery charger 18 when the proper polarity connection of the battery is detected and prevent charging of the battery 16 with the battery charger 18 when a reverse polarity connection of the battery 16 to the battery connector 50 is detected. It should be appreciated that the diode D40 which is connected in parallel with the battery charger 18 is also connected in parallel with the relay switch S1 and relay coil C1.

The battery charger protection circuit 200 further includes a main power supply input 75 coupled to control transistor Q18 across resistors R177 and R178. The availability of the main power supply Vₚₛ is required to turn on transistor Q18 to allow electric current to flow through diode D40 and the relay K3 to ground to charge the battery 16.

In operation, when a battery 16 is connected according to the proper voltage polarity to the battery connector 16 via terminals 52A and 52B, electric current flows through the diode D40 and the relay coil C1 which causes the relay switch S1 to close to form a closed circuit between the charger 18 and the battery 16 thereby allowing the battery charger 18 to electrically power and charge the battery 16 to the battery voltage V_{bat}. When the battery 16 is connected in a reverse polarity, the negative polarity of the battery 16 connected to the first terminal 52A does not allow current to flow through the diode D40 and relay coil C1 such that the relay coil C1 has no current flow and therefore the relay switch S1 remains in the open circuit position, thereby preventing charging of the battery 16 with the battery charger 18.

The battery charger protection circuit 200 advantageously prevents the charging of the rechargeable battery 16 via the battery charger 18 when a reverse polarity battery connection is detected by employing relay K3 and diode D40 in a circuit configuration that minimizes the consumption of electrical power transmitted through the relay coil C1 which may have a resistance of approximately 2.079 kΩ, for example. The battery charger protection circuit 200 disconnects the battery 16 from the charger 18 when no power is available from the main power supply and a reverse polarity connection of the battery is detected which protects the charger from the reverse polarity connection, eliminates back-feeding into the circuitry and reduces the battery leakage through the charger networks. The battery charger protection circuit 200 may advantageously be employed on the patient support apparatus 12 as shown and described herein. It should further be appreciated that the battery charger protection circuit 200 may be employed for use with a battery charger and rechargeable battery for use on other devices to power other electrical loads and charge the rechargeable battery.

It will be understood by one having ordinary skill in the art that construction of the described disclosure and other components is not limited to any specific material. Other exemplary embodiments of the disclosure disclosed herein may be formed from a wide variety of materials, unless described otherwise herein.

For purposes of this disclosure, the term "coupled" (in all of its forms, couple, coupling, coupled, etc.) generally means the joining of two components (electrical or mechanical) directly or indirectly to one another. Such joining may be stationary in nature or movable in nature. Such joining may be achieved with the two components (electrical or mechanical) and any additional intermediate members being integrally formed as a single unitary body with one another or with the two components. Such joining may be permanent in nature or may be removable or releasable in nature unless otherwise stated.

As used herein, the term "about" means that amounts, sizes, formulations, parameters, and other quantities and characteristics are not and need not be exact, but may be approximate and/or larger or smaller, as desired, reflecting tolerances, conversion factors, rounding off, measurement error and the like, and other factors known to those of skill in the art. When the term "about" is used in describing a value or an end-point of a range, the disclosure should be understood to include the specific value or end-point referred to. Whether or not a numerical value or end-point of a range in the specification recites "about," the numerical value or end-point of a range is intended to include two embodiments: one modified by "about," and one not modified by "about." It will be further understood that the end-points of each of the ranges are significant both in relation to the other end-point, and independently of the other end-point.

The terms "substantial," "substantially," and variations thereof as used herein are intended to note that a described feature is equal or approximately equal to a value or description. For example, a "substantially planar" surface is intended to denote a surface that is planar or approximately planar. Moreover, "substantially" is intended to denote that two values are equal or approximately equal. In some embodiments, "substantially" may denote values within about 10% of each other, such as within about 5% of each other, or within about 2% of each other.

It is also important to note that the construction and arrangement of the elements of the disclosure, as shown in the exemplary embodiments, is illustrative only. Although only a few embodiments of the present innovations have been described in detail in this disclosure, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter recited. For example, elements shown as integrally formed may be constructed of multiple parts, or elements shown as multiple parts may be integrally formed, the operation of the interfaces may be reversed or otherwise varied, the length or width of the structures and/or members or connector or other elements of the system may be varied, the nature or number of adjustment positions provided between the elements may be varied. It should be noted that the elements and/or assemblies of the system may be constructed from any of a wide variety of materials that provide sufficient strength or durability, in any of a wide variety of colors, textures, and combinations. Accordingly, all such modifications are intended to be included within the scope of the present innovations. Other substitutions, modifications, changes, and omissions may be made in the design, operating conditions, and arrangement of the desired and other exemplary embodiments without departing from the spirit of the present innovations.

It will be understood that any described processes or steps within described processes may be combined with other disclosed processes or steps to form structures within the scope of the present disclosure. The exemplary structures and processes disclosed herein are for illustrative purposes and are not to be construed as limiting.

Embodiments of the invention can be described with reference to the following numbered clauses, with preferred features laid out in the dependent clauses:
1. A battery protection circuit has a battery input configured to receive a battery voltage. A reference voltage input is configured to receive a low battery reference voltage. A comparator is included for comparing a first signal indicative of the battery voltage with a second signal indicative of the reference voltage and generating an output indicative of a low battery voltage. A feedback resistor couples the output of the comparator to the reference voltage input to create hysteresis. A battery disconnect circuit is configured to disconnect the battery voltage applied to an electrical load.
2. A battery system has a battery with one or more battery cells for generating a battery voltage. An electrical load is configured to receive the battery voltage to power the electrical load configured to receive the battery voltage to power the electrical load. A battery system also has a battery protection circuit. The battery protection circuit has a battery input configured to receive the battery voltage. A reference voltage input is configured to receive a low battery reference voltage. A comparator is included for comparing a first signal indicative of the battery voltage with a second signal indicative of the reference voltage and generating at a comparator output comparator signal indicative of a low battery voltage. A feedback resistor couples the comparator output of the comparator to the reference voltage input to create hysteresis. A battery disconnect circuit disconnects the battery voltage applied to the electrical load.
3. A reverse polarity battery charger protection circuit includes a battery charger input configured to receive a charging voltage from a battery charger. A battery connector is configured to couple with first and second polarity outputs of a battery. A relay is coupled in series with the battery charger input. A diode is configured to be coupled in parallel with the battery charger. A transistor is coupled to the relay and the diode. The diode and relay allow charging of the battery with the battery charger and prevent charging of the battery with the battery charger when a reverse polarity connection of the battery to the battery connector is detected.
4. A battery charging system has a battery having one or more battery cells for generating a battery voltage, a battery charger generating a charging voltage to charge the battery, and a reverse polarity battery charging protection circuit coupling the battery charger to the battery. The reverse polarity battery charging protection circuit has a battery charger input configured to receive a charging voltage from the battery charger. A battery connector is configured to couple with first and second polarity outputs of the battery. A relay is coupled in series with the battery charger input. A diode is coupled in parallel with the battery charger. A transistor is coupled to the relay and the diode, wherein the diode and relay allow charging of the battery with the battery charger and prevent charging of the battery with the battery charger when a reverse polarity connection of the battery to the battery connector is detected.
5. The battery protection circuit as in clause 1, wherein the first signal comprises a first voltage and the second signal comprises a second voltage.
6. The battery protection circuit as in any one of clauses 1 and 5, wherein the battery protection circuit further has a first resistor divider network coupled to the battery voltage to generate the first voltage.
7. The battery protection circuit as in any one of clauses 1 and 5 to 6, wherein the battery protection circuit further has a second resistor divider network coupled to the reference voltage input to generate the second signal.
8. The battery protection circuit as in any one of clauses 1 and 5 to 7, wherein each of the first and second resister divider networks of the battery protection circuit has a first resistor and a second resistor, and wherein the first and second resistors each have a resistance greater than 50 kΩ.
9. The battery protection circuit as in any one of clauses 1 and 5 to 8, wherein the battery disconnect circuit reconnects the battery voltage to the electrical load when the first signal exceeds the second signal by an amount of the hysteresis.
10. The battery protection circuit as in any one of clauses 1 and 5 to 9, wherein the battery disconnect circuit comprises a relay configured to disconnect the battery from the electrical load.
11. The battery protection circuit as in any one of clauses 1 and 5 to 10, wherein the battery disconnect circuit has OR logic circuitry receiving the output of the comparator and main power supply signal.
12. The battery protection circuit as in any one of clauses 1 and 5 to 11, wherein the battery is configured for use on a bed to power one or more electrically powered devices.
13. The battery protection circuit as in any one of clauses 1 and 5 to 12, wherein the battery is a lead acid battery.
14. The battery system as in clause 2, wherein the first signal comprises a first voltage and the second signal comprises a second voltage.
15. The battery system as in any one of clauses 2 and 14, wherein the battery system further has a first resistor divider network coupled to the battery voltage to generate the first voltage.
16. The battery system as in any one of clauses 2 and 14 to 15, wherein the battery system further has a second resistor divider network coupled to the reference voltage input to generate the second signal.
17. The battery system as in any one of clauses 2 and 14 to 16, wherein each of the first and second resister divider networks of the battery system has a first resistor and a second resistor. The first and second resistors each have a resistance greater than 50 kΩ.
18. The battery system as in any one of clauses 2 and 14 to 17, wherein the battery disconnect circuit reconnects the battery voltage to the load when the first signal exceeds the second signal by an amount of the hysteresis.
19. The battery system as in any one of clauses 2 and 14 to 18, wherein the battery disconnect circuit comprises a relay configured to disconnect the battery from the load.
20. The battery system as in any one of clauses 2 and 14 to 19, wherein the battery system has OR logic circuitry to receive the output of the comparator and an override signal.
21. The battery system as in any one of clauses 2 and 14 to 20, wherein the battery is configured for use on a bed to power one or more electrically powered devices.
22. The battery system as in any one of clauses 2 and 14 to 21, wherein the battery is a lead acid battery.
23. The reverse polarity battery charger protection circuit in clause 3, wherein the relay comprises a relay coil and a relay switch, wherein electric current from the battery flows through the diode and the relay coil to close the relay switch to couple power from the battery charger to the battery.
24. The reverse polarity battery charger protection circuit in any one of clauses 3 and 23, wherein a reverse polarity connection of the battery to the battery connector input prevents current from flowing through the diode and the relay coil which causes the relay switch to disconnect the battery charger from the battery.
25. The reverse polarity battery charger protection circuit in any one of clauses 3 and 23 to 24, wherein the transistor has an input coupled to a main power supply signal.
26. The reverse polarity battery charger protection circuit in any one of clauses 3 and 23 to 25, wherein the main power supply supplies a DC voltage signal.
27. The reverse polarity battery charger protection circuit in any one of clauses 3 and 23 to 26, wherein an AC to DC converter may be used for converting an AC voltage to the DC voltage.
28. The reverse polarity battery charger protection circuit in any one of clauses 3 and 23 to 27, wherein the battery is configured for use on a bed to power one or more electrical powered devices.
29. The reverse polarity battery charger protection circuit in any one of clauses 3 and 23 to 29, wherein the battery is a lead acid battery.
30. The battery charging system in clause 4, wherein the relay comprises a relay coil and a relay switch, wherein electric current from the battery flows through the diode and the relay coil to close the relay switch to couple power from the battery charger to the battery.
31. The battery charging system in any one of clauses 4 and 30, wherein a reverse polarity connection of the battery to the battery connector input prevents current from flowing through the diode and the relay coil which causes the relay switch to disconnect the battery charger from the battery.
32. The battery charging system in any one of clauses 4 and 30 to 31, wherein the transistor has an input coupled to a main power supply signal.
33. The battery charging system in any one of clauses 4 and 30 to 32, wherein the main power supply supplies a DC voltage.
34. The battery charging system in any one of clauses 4 and 30 to 33, wherein battery charging system also has an AC to DC converter for converting an AC voltage to the DC voltage.
35. The battery charging system in any one of clauses 4 and 30 to 34, wherein the battery is configured for use on a bed to power one or more electrical powered devices.
36. The battery charging system in any one of clauses 4 and 30 to 35, wherein the battery is a lead acid battery.

## Claims

1. A battery protection circuit (100) comprising:
a battery input (17) configured to receive a battery voltage (V_{bat});
a reference voltage input (19) configured to receive a low battery reference voltage;
a comparator (U15) for comparing a first signal indicative of the battery voltage with a second signal indicative of the reference voltage and generating an output indicative of a low battery voltage;
a feedback resistor (R172) coupling the output of the comparator (U15) to the reference voltage input (19) to create hysteresis; and
a battery disconnect circuit (100) configured to disconnect the battery voltage applied to an electrical load (34).

2. The battery protection circuit (100) according to claim 1, wherein the first signal comprises a first voltage and the second signal comprises a second voltage.

3. The battery protection circuit (100) according to claim 2, further comprising a first resistor divider network (R175, R176) coupled to the battery voltage to generate the first voltage.

4. The battery protection circuit (100) as claimed in claim 3 further comprising a second resistor divider network (R173, R174) coupled to the reference voltage input (19) to generate the second signal.

5. The battery protection circuit (100) according to claim 4, wherein each of the first and second resister divider networks (R175, R176, R173, R174) comprises a first resistor and a second resistor, and wherein the first and second resistors each have a resistance greater than 50 kΩ.

6. The battery protection circuit (100) according to any preceding claim, wherein the battery disconnect circuit (100) reconnects the battery voltage (V_{bat}) to the electrical load (34) when the first signal exceeds the second signal by an amount of the hysteresis, and wherein the battery disconnect circuit (100) comprises a relay configured to disconnect the battery (16) from the electrical load (34).

7. The battery protection circuit (100) according to any preceding claim, further comprising OR logic circuitry receiving the output of the comparator and main power supply signal.

8. The battery protection circuit (100) according to any preceding claim, wherein the battery (16) is configured for use on a bed to power one or more electrically powered devices.

9. The battery protection circuit (100) according to any preceding claim, wherein the battery (16) is a lead acid battery.

10. A battery system comprising:
a battery (16) having one or more battery cells for generating a battery voltage;
an electrical load (34) configured to receive the battery voltage to power the electrical load; and
the battery protection circuit (100) as claimed in any preceding claim.

11. A reverse polarity battery charger protection circuit (200) comprising:
a battery charger protection circuit as claimed in any preceding claim, the input (70) configured to receive a charging voltage from a battery charger (18);
a battery connector (50) configured to couple with first and second polarity outputs of a battery;
a relay (k3) coupled in series with the battery charger input (70);
a diode (D40) configured to be coupled in parallel with the battery charger (18); and
a transistor (Q18) coupled to the relay (k3) and the diode (D40), wherein the diode (D40) and relay (k3) allow charging of the battery (16) with the battery charger (18) and prevent charging of the battery (16) with the battery charger (18) when a reverse polarity connection of the battery (16) to the battery connector (50) is detected.

12. The reverse polarity battery charger protection circuit (200) of claim 11, wherein the relay (K3) comprises a relay coil (C1) and a relay switch (S2), wherein electric current from the battery (16) flows through the diode (D40) and the relay coil (C1) to close the relay switch (S2) to couple power from the battery charger (18) to the battery (16), and wherein a reverse polarity connection of the battery (16) to the battery connector input prevents current from flowing through the diode (D40) and the relay coil (C1) which causes the relay switch (S2) to disconnect the battery charger (18) from the battery (16).

13. The reverse polarity battery charger protection circuit (200) of either claim 11 or claim 12, wherein the transistor (Q18) has an input coupled to a main power supply signal, and wherein the main power supply supplies a DC voltage signal, and further comprising an AC to DC converter for converting an AC voltage to the DC voltage.

14. The reverse polarity battery charger protection circuit (200) of any one of claims 11 to 13, wherein the battery (16) is configured for use on a bed to power one or more electrical powered devices.

15. The reverse polarity battery charger protection circuit (200) of any one of claims 11 to 14, wherein the battery (16) is a lead acid battery.
